# EUROPÄISCHE PATENTSCHRIFT

(11) **EP 0 886 998 B1**
(45) Veröffentlichungstag und Bekanntmachung des Hinweises auf die Patenterteilung: **08.09.1999**
(21) Anmeldenummer: 97915329.3
(22) Anmeldetag: 04.03.1997
(51) Int. Cl.: H05K 9/00, H05K 7/14

(54) **ECKPROFILLEISTE FÜR ELEKTROMAGNETISCH ABGESCHIRMTEN BAUGRUPPENTRÄGER**
CORNER-PROFILE STRIP FOR ELECTROMAGNETICALLY SHIELDED MOUNTING RACK
MOULURE PROFILEE ANGULAIRE POUR CHASSIS EQUIPEE A PROTECTION ELECTROMAGNETIQUE

(30) Priorität: 12.03.1996 DE 29604450 U
(43) Veröffentlichungstag der Anmeldung: 30.12.1998
(73) Patentinhaber: SIEMENS AKTIENGESELLSCHAFT, 80333 München (DE)
(72) Erfinder: KURRER, Siegfried, D-90449 Nürnberg (DE); KÖRBER, Werner, D-91282 Betzenstein (DE); BILLENSTEIN, Ernst, D-91593 Burgbernheim (DE); SCHAFFER, Kurt-Michael, D-90542 Eckental (DE)
(86) Internationale Anmeldenummer: DE9700398
(87) Internationale Veröffentlichungsnummer: WO9734458

(56) Entgegenhaltungen:
- EP-A- 0 516 986
- DE-C- 4 130 355
- DE-U- 29 509 102
- RADIO FERNSEHEN ELEKTRONIK, Bd. 41, Nr. 3, 1.Januar 1992, Seite 211 XP000256735 "HF-GEDICHTETE FRONTPLATTEN"

## Beschreibung

Um eine störungsfreie Funktion von elektrischen Schaltungen und dergleichen gewährleisten zu können, ist es notwendig, diese gegen elektromagnetische Wellen abzuschirmen. Hierzu muß das Gehäuse, welches die elektrische Schaltung umgibt, überwiegend aus metallischen Gehäuseteilen bestehen. Dabei verhindert die Abschirmung sowohl ein Eindringen von elektromagnetischen Wellen, als auch deren Austreten aus dem Gehäuse. Hierzu ist es erforderlich, daß zwischen den metallischen Gehäuseteilen durchgehend elektrisch leitende Verbindungen, insbesondere über Kontaktfederelemente, hergestellt werden. Abhängig von der Höhe der elektromagnetischen Frequenzen müssen diese Verbindungen möglichst lückenlos sein.

Aus dem Siemens-Katalog "Einbautechnik und Stromversorgung für Industrieelektronik", Katalog ET1, 1983 ist auf der dortigen Seite 2/13 ein elektromagnetisch abgeschirmter Baugruppenträger dargestellt. Die Seitenwände weisen dabei im Frontbereich einen Befestigungsflansch auf, der gleichzeitig einen Eckbereich bildet. Die elektromagnetische Abschirmung eines im Seitenbereich eingeschobenen Geräteeinschubs erfordert eine Kontaktierung dessen Frontplatte mit der Seitenwand des Baugruppenträgers. Dies ist beim Baugruppenträger des vorliegenden Dokuments aber nur über ein nicht dargestelltes, zusätzliches Bauteil in Form eines vorderen Aufnahmeprofils möglich, welches ausschließlich der elektrischen Kontaktherstellung zwischen einer außen liegenden Frontplatte und der Seitenwand dient.

Aus dem Katalog "Systeme zur Abschirmung elektromagnetischer Störeinflüsse" der Firma Schroff, 9/94, Bestellnummer D 9/94 7/7 (39600-100) ist gemäß der dortigen Seite 53 ein Baugruppenträgersystem bekannt. Dieses weist für jeden Eckbereich ein Eckprofil, sowie zur elektromagnetischen Abschirmung zusätzlich noch eine Kontakt- oder Trägerleiste und einen untergelegten HF-Kontaktstreifen auf. Die Kontakt- oder Trägerleisten dienen zur Kontaktierung der Frontplatten der Gehäuseeinschübe mit dem Gehäuse selbst, wodurch die elektromagnetische Abschirmung erfolgt. Nachteilhaft ist, daß die elektrische Kontaktierung zwischen den Frontplatten der Geräteeinschübe und den Seitenwänden nur durch die zusätzlich montierten Kontaktleisten, Trägerleisten und die HF-Kontaktstreifen realisierbar ist. Dies erfordert nicht nur einen erhöhten Material- und Montageaufwand, sondern hat im Baugruppenträger einen nicht zu vernachlässigen Raumverlust zur Folge.

Aus dem Dokument EP-A-0 516 986 ist ein abgeschirmter Baugruppenträger bekannt, der zwei Befestigungswinkel aufweist, die jeweils mit einer Seitenwand im Frontbereich des Baugruppenträgers verbunden sind. Jeder Befestigungswinkel weist des weiteren einen leistenförmigen Auflageschenkel für die Seitenwand und einen zum Auflageschenkel annähernd orthogonalen, leistenförmigen Abstandsschenkel auf. Um einen elektrisch gut leitenden Übergang zwischen den Frontplatten und den Seitenwänden zu erzielen, sind zusätzliche Leisten vorgesehen, die in die Ecken zwischen den Seitenwänden und deren fontseitig abgewinkelten Rändern mit Schrauben befestigt sind.

Der Erfindung liegt die Aufgabe zugrunde, eine demgegenüber wirkungsvollere und einfacher handhabbare elektromagnetische Abschirmung des Eckbereichs eines Baugruppenträgers anzugeben.

Die Aufgabe wird gelöst mit der im Anspruch 1 angegebenen Eckprofilleiste für einen elektromagnetisch abgeschirmten Baugruppenträger. Diese weist einen leistenförmigen Auflageschenkel für eine seitliche Gehäuseplatte, einen zum Auflageschenkel annähernd orthogonalen, leistenförmigen Abstandsschenkel und einen leistenförmigen Kontaktschenkel auf, welcher annähernd parallel zum Auflageschenkel vom Abstandsschenkel nach innen gerichtet ist.

Vorteil der Eckprofilleiste gemäß der Erfindung ist die einteilige Ausführung der Eckprofilleiste eines elektromagnetisch abgeschirmten Baugruppenträgers komplett mit Kontaktschenkel. Der Kontaktschenkel der erfindungsgemäßen Eckprofilleiste kann beispielsweise derartig ausgebildet sein, daß einerseits eine Kontaktfederleiste aufsteckbar ist und gleichzeitig dessen Außenseite als Kontaktfläche für anliegende Federelemente dient. Die Eckprofilleiste ist somit universell insbesondere an gegenüberliegenden Gehäuseplatten verwendbar. Dies hat zur Folge, daß beispielsweise auf der einen Seite eines Baugruppenträgers eine Eckprofilleiste mit einer Kontaktfederleiste bestückbar ist und auf der gegenüberliegenden Seite eine baugleiche Eckprofilleiste eine Kontaktfläche zur Verfügung stellt. Dies ermöglicht vorteilhaft eine vereinfachte Herstellung und Montage der erfindungsgemaßen Eckprofilleiste.

Ein weiterer Vorteil ist die bessere Raumausnutzung im Eckbereich, welches die einteilige Ausführung der Eckprofilleiste ermöglicht. Der durch die erfindungsgemäße Eckprofilleiste verbrauchte Raum im Inneren des elektromagnetisch abgeschirmten Baugruppenträgers wird auf ein Minimum reduziert. Die Geräteeinschübe des Baugruppenträgers können unmittelbar neben einer Eckprofilleiste eingeschoben und mit dieser kontaktiert werden, wodurch die elektromagnetische Abschirmung erfolgt.

Die einteilige Ausführung von Auflage- und Kontaktschenkel über einen Abstandsschenkel ermöglicht vorteilhaft die einteilige Herstellung der erfindungsgemäßen Eckprofilleiste insbesondere durch Strangpressen. Die Materialdicke der Eckprofilleiste ist weitgehendst unabhängig von der Dicke der Gehäuseplatten. Somit kann der Kontaktschenkel der erfindungsgemäßen Eckprofilleiste vorteilhaft derartig gestaltet sein, daß auch ein unmittelbares Aufstecken von Federelementen möglich ist.

Weitere vorteilhafte Ausführungsformen der Erfindung sind in den entsprechenden Unteransprüchen angegeben.

Die Erfindung wird desweiteren anhand des in den nachfolgend kurz angeführten Figuren dargestellten Ausführungsbeispieles weiter erläutert. Dabei zeigt
- FIG 1: beispielhaft eine perspektivische Darstellung einer Eckprofilleiste gemäß der Erfindung,
- FIG 2: beispielhaft eine perspektivische Darstellung einer Eckprofilleiste gemäß der Erfindung mit einem gemäß einer weiteren Ausführungsform zusätzlich einteilig angeformten Befestigungsflansch und
- FIG 3: beispielhaft einen Querschnitt der Eckprofilleiste gemäß der Erfindung, welche an einer Gehäusewand angebracht ist und wobei auf den Kontaktschenkel eine Federprofilleiste aufgesteckt ist.

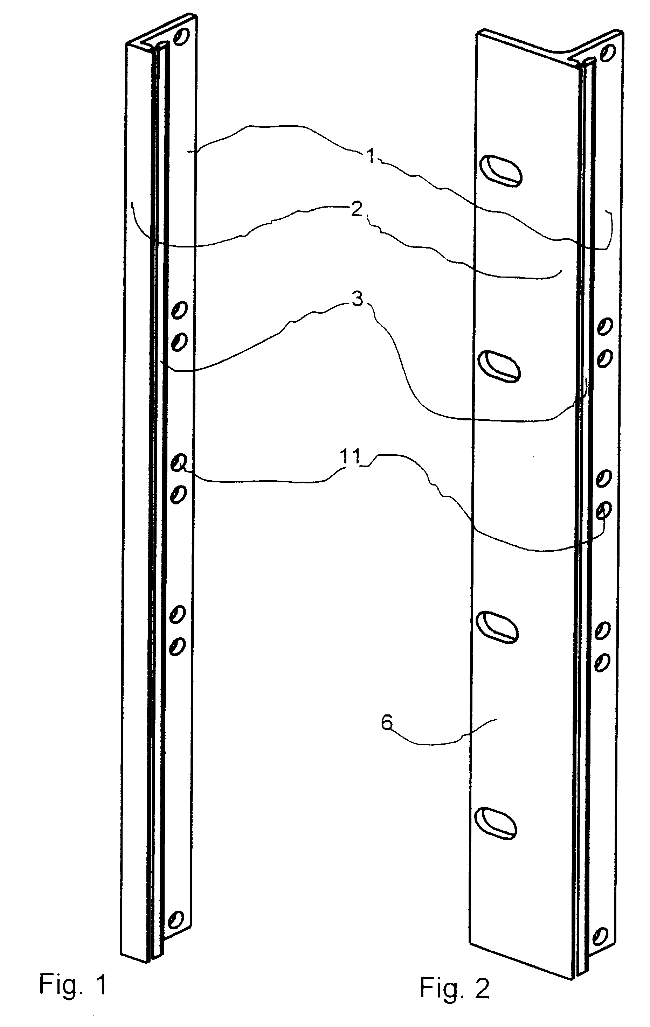

In Figur 1 ist beispielhaft die Eckprofilleiste gemäß der Erfindung dargestellt. Diese weist einen leistenförmigen Auflageschenkel 1 und einen zu diesem annähernd orthogonal angeordneten, leistenförmigen Abstandsschenkel 2 auf. Desweiteren ist am anderen Ende des Abstandsschenkels 2 ein annähernd orthogonal nach innen und annähernd parallel zum Auflageschenkel 1 gerichteter leistenförmiger Kontaktschenkel 3 angeordnet. Auflageschenkel 1, Abstandsschenkel 2 und Kontaktschenkel 3 bilden somit die erfindungsgemäße, einteilige Eckprofilleiste. Diese ermöglicht insbesondere die elektromagnetische Abschirmung auch im Kantenbereich von Gehäusewänden. Der Auflageschenkel 1 weist insbesondere Bohrungen 11 auf, um die Eckprofilleiste im Randbereich von in Figur 1 nicht dargestellten Gehäuseplatten eines Baugruppenträgers anzubringen. Das Eckprofil kann beispielsweise an der linken vorderen Seite und ein entsprechend gedrehtes Eckprofil kann an der gegenüberliegenden rechten Seite eines Baugruppenträgers angebracht sein.

In Figur 2 ist desweiteren eine Ausführungsvariante der erfindungsgemäßen Eckprofilleiste mit einem leistenförmigen Befestigungsflansch 6 dargestellt. Dieser ist annähernd orthogonal zum Auflageschenkel 1 und annähernd bündig zur Vorderseite des Abstandsschenkels 2 einteilig an der erfindungsgemäßen Eckprofilleiste angeformt. Beispielsweise können zwei vordere, gegenüberliegende Seiten eines Baugruppenträgers erfindungsgemäße Eckprofilleisten aufweisen, wodurch dieser mittels der Befestigungsflansche der Eckprofilleisten an einem Schaltschrank befestigbar ist.

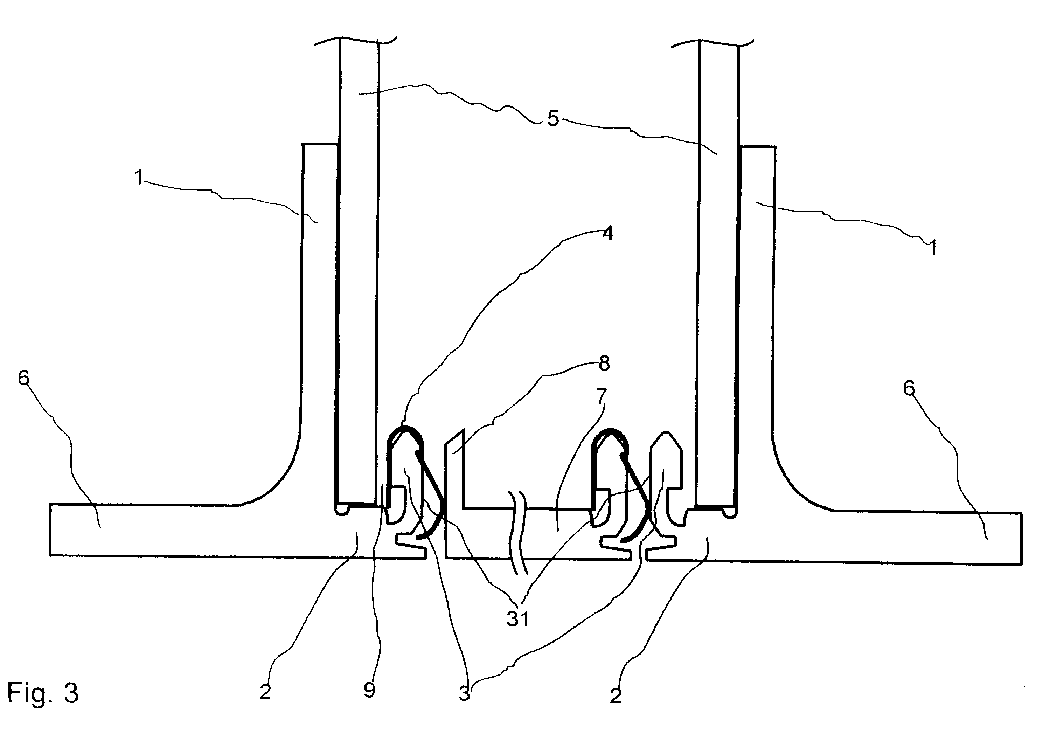

In Figur 3 ist beispielhaft ein Querschnitt durch eine Eckprofilleiste gemäß der Erfindung dargestellt. Diese ist an einer Gehäuseplatte 5 eines elektromagnetisch abgeschirmten Baugruppenträgers, beispielsweise jeweils an einer gegenüberliegenden Seitenwand, angebracht. Die Eckprofilleiste kann sowohl über die außen liegende Fläche, als auch über die innen liegende Fläche des Auflageschenkels 1 mit der Gehäuseplatte 5 verbunden sein. Vorteilhaft ist in einer Ausführungsvariante der erfindungsgemäßen Eckprofilleiste der Kontaktschenkel 3 insbesondere derartig an dem Abstandsschenkel 2 angeordnet, daß eine U-förmige Aussparung 9 entsteht, welche durch Auflageschenkel 1 und Kontaktschenkel 3 begrenzt ist. In der U-förmigen Aussparung 9 ist insbesondere die Seitenkante der Gehäuseplatte 5 einlegbar und diese dadurch am Auflageschenkel 1 stabil und unmittelbar kontaktierend anbringbar. Die Eckprofilleiste umschließt somit den Kantenbereich der Gehäuseplatte 5. Die Eckprofilleiste kann wiederum zusätzlich einen leistenförmigen Befestigungsflansch 6 aufweisen. Beispielsweise kann die Eckprofilleiste jeweils im vorderen Kantenbereich von zwei gegenüberliegenden Seitenwänden eines Baugruppenträgers angebracht sein.

In einer weiteren Ausführungsvariante der erfindungsgemäßen Eckprofilleiste ist der leistenförmige Kontaktschenkel 3 derartig ausgebildet, daß Federelemente 4, insbesondere eine Kontaktfederleiste, aufsteckbar sind. Diese sind federnd von der Außenseite 31 des Kontaktschenkels 3 abgespreizt und dienen zur Kontaktierung mit benachbarten Gehäuseteilen. Im Ausführungsbeispiel der Figur 3 ist dies beispielhaft durch ein benachbartes Gehäuseteil 7 dargestellt. Dabei kann es sich beispielsweise um eine Front-, Rück-, Seitenwand, ein Geräteeinschub oder eine Abdeckplatte des Gehäuses handeln. Das Gehäuseteil 7 weist insbesondere zusätzlich einen Kontaktschenkel 8 auf, gegen welchen die Federelemente 4 federnd anliegen. Dadurch wird ein elektrischer Kontakt zwischen der Gehäuseplatte 5, an welcher die Eckprofilleiste angebracht ist und dem Gehäuseteil 7 hergestellt. Dies ermöglicht die elektromagnetische Abschirmung des Gehäuses auch in den Eckbereichen. Die Außenseite 31 des Kontaktschenkels 3 kann dabei insbesondere derartig ausgebildet sein, daß diese zusätzlich gleichzeitig auch als Kontaktfläche dient.

Vorteil der erfindungsgemäßen Eckprofilleiste ist deren einteilige Ausführungsform. Die erfindungsgemäße Eckprofilleiste verbindet die Funktionalität eines mechanischen Verbindungsbauteils für wesentliche Gehäuseteile mit der Funktionalität eines Kontaktierungsbauteils zur elektromagnetischen Abschirmung des Baugruppenträgers. Dabei ist diese sowohl zur Halterung von Kontaktfederleisten geeignet, als auch als Kontaktgegenfläche zu Federelementen. Somit wird einerseits der Herstellungsaufwand und andererseits der Montageaufwand reduziert. Dies hat zur Folge, daß eine einzige Ausführung der erfindungsgemäßen Eckprofilleiste an allen vier Ecken eines Baugruppenträgers eingesetzt werden kann. Der durch die erfindungsgemäße Eckprofilleiste verbrauchte Raum im Inneren des elektromagnetisch abgeschirmten Baugruppenträgers bleibt auf ein Minimum beschränkt. Desweiteren ermöglicht die separat von Gehäusewänden herstellbare Eckprofilleiste gemäß der Erfindung insbesondere eine derartige Ausbildung des Kontaktschenkels 3, daß das Aufstecken von Federelementen 4, insbesondere einer Kontaktfederleiste, möglich ist. Die vorteilhaft möglichst niedrige Höhe des Kontaktschenkels 3 ermöglicht somit einen nur wenig im Baugruppenträger liegenden Kontaktpunkt zwischen den Federelementen 4 und dem Kontaktschenkel 8 eines benachbarten Gehäuseteils 7. Die durch die erfindungsgemäße Eckprofilleiste außen am Baugruppenträger verlaufende elektrische Kontaktierung zwischen den Gehäuseteilen bewirkt im Eckbereich eine nahezu ideale elektromagnetische Abschirmung. Die Federelemente 4 bzw. die Kontaktfederleiste, sind vorteilhaft so ausgebildet, daß nur eine einzige Ausführungsform einer aufsteckbaren Kontaktfeder am gesamten Baugruppenträger verwendet werden kann.

## Patentansprüche

1. Eckprofilleiste für einen elektromagnetisch abgeschirmten Baugruppenträger, welche aufweist
a) einen leistenförmigen Auflageschenkel (1) für eine seitliche Gehäuseplatte (5),
b) einen zum Auflageschenkel (1) annähernd orthogonalen, leistenförmigen Abstandsschenkel (2),
c) und einen leistenförmigen Kontaktschenkel (3), welcher annähernd parallel zum Auflageschenkel (1) vom Abstandsschenkel (2) nach innen gerichtet ist.

2. Eckprofilleiste nach einem der vorangegangenen Ansprüche, wobei der Abstandsschenkel (2) derartig ausgebildet ist, daß durch Auflageschenkel (1) und Kontaktschenkel (3) eine U-förmige Aussparung (9) begrenzt ist, in welche die Seitenkante einer Gehäuseplatte (5) einlegbar und am Auflageschenkel (1) anbringbar ist.

3. Eckprofilleiste nach einem der vorangegangenen Ansprüche, wobei der leistenförmige Kontaktschenkel (3) derartig ausgebildet ist, daß Federelemente (4), insbesondere eine Kontaktfederleiste, aufsteckbar sind.

4. Eckprofilleiste nach einem der vorangegangenen Ansprüche, wobei die Außenseite des leistenförmigen Kontaktschenkels (3) als eine Kontaktfläche ausgebildet ist.

5. Eckprofilleiste nach einem der vorangegangenen Ansprüche, welche zusätzlich einen einteilig angeformten Befestigungsflansch (6) aufweist, welcher annähernd orthogonal zum Auflageschenkel (1) und annähernd bündig zur Vorderseite des Abstandsschenkels (2) angeordnet ist.

## Claims

1. Corner shaped strip for an electromagnetically screened subrack, which has
a) a strip-shaped bearing limb (1) for a lateral housing plate (5),
b) a strip-shaped spacer limb (2) which is approximately orthogonal to the bearing limb (1),
c) and a strip-shaped contact limb (3), which is directed inwards from the spacer limb (2) in a fashion approximately parallel to the bearing limb (1).

2. Corner shaped strip according to one of the preceding claims, in which the spacer limb (2) is designed in such a way that the bearing limb (1) and contact limb (3) bound a U-shaped recess (9) into which the side edge of a housing plate (5) can be inserted and can be fitted on the bearing limb (1).

3. Corner shaped strip according to one of the preceding claims, in which the strip-shaped contact limb (3) is designed in such a way that spring elements (4), in particular a contact socket connector, can be plugged on.

4. Corner shaped strip according to one of the preceding claims, in which the outer side of the strip-shaped contact limb (3) is designed as a contact surface.

5. Corner shaped strip according to one of the preceding claims, which additionally has a fastening flange (6) which is integrally formed and is arranged approximately orthogonal to the bearing limb (1) and approximately flush with the front side of the spacer limb (2).

## Revendications

1. Baguette profilée angulaire pour un châssis équipé à blindage électromagnétique, qui comporte
a) une branche (1) d'appui en forme de baguette pour une plaque (5) latérale de boîtier,
b) une branche (2) d'écartement en forme de baguette, à peu près orthogonale à la branche (1) d'appui,
c) et une branche (3) de contact en forme de baguette, qui est dirigée depuis la branche (2) d'écartement vers l'intérieur à peu près parallèlement à la branche (1) d'appui.

2. Baguette profilée angulaire suivant la revendication 1, suivant laquelle la branche (2) d'écartement est conçue de telle sorte que la branche (1) d'appui et la branche (3) de contact délimitent un évidement (9) en forme de U, dans lequel le bord latéral d'une plaque (5) de boîtier peut être inséré et appliqué contre la branche (1) d'appui.

3. Baguette profilée angulaire suivant l'une des revendications précédentes, suivant laquelle la branche (3) de contact en forme de baguette est conçue de telle sorte que des éléments (4) élastiques, notamment une baguette élastique de contact, peuvent y être enfilés.

4. Baguette profilée angulaire suivant l'une des revendications précédentes, suivant laquelle le côté extérieur de la branche (3) de contact en forme de baguette est conçu comme face de contact.

5. Baguette profilée angulaire suivant l'une des revendications précédentes, qui comporte en plus, d'un seul tenant, une bride (6) de fixation, qui est disposée à peu près orthogonalement à la branche (1) d'appui et environ à fleur du côté avant de la branche (2) d'écartement.
